Europäisches Patentamt

European Patent Office

Office européen des brevets

(19)

(11) Veröffentlichungsnummer: **0 126 354 B1**

# EUROPÄISCHE PATENTSCHRIFT

(45) Veröffentlichungstag der Patentschrift: **27.02.91**

(51) Int. Cl.⁵: **H03J 5/24**

(21) Anmeldenummer: **84105077.6**

(22) Anmeldetag: **05.05.84**

(54) Eingangsschaltungsanordnung für Fernsehempfangsgeräte.

(30) Priorität: **19.05.83 DE 3318197**

(43) Veröffentlichungstag der Anmeldung:
**28.11.84 Patentblatt 84/48**

(45) Bekanntmachung des Hinweises auf die
Patenterteilung:
**27.02.91 Patentblatt 91/09**

(84) Benannte Vertragsstaaten:
**DE FR GB IT LU NL**

(56) Entgegenhaltungen:
**DE-A- 2 311 109          DE-A- 2 753 578
DE-B- 2 249 582          FR-A- 1 403 806
GB-A- 2 025 178          US-A- 3 696 302**

(73) Patentinhaber: **Deutsche Thomson-Brandt
GmbH
Hermann-Schwer-Strasse 3 Postfach 1307
D-7730 Villingen-Schwenningen(DE)**

(72) Erfinder: **Maier, Gerhard
Reutestrasse 19
D-7735 Dauchingen(DE)**

## Beschreibung

Stand der Technik

Die Erfindung bezieht sich auf eine Schaltungsanordnung für Fernsehempfänger nach dem Obergriff des Patentanspruchs.

Eine derartige Anordnung ist aus der DE-A-2311109 die von den in der Tuner enthaltenen Mischtufen abgenommenen Signale über Entkopplungsdioden einem gemeinsamen Zwischenfrequenzkreis zugeführt. Dies hat jedoch mehrere Nachteile, die sich darin ausdrücken, daß in der Produktion nach der elektrischen Verbindung der Tuner mit dem Zwischenfrequenz verstärker beide neu auf die Zwischenfrequenz abgeglichen werden müssen wegen der unterschiedlichen Ausgangsimpedanzen der beiden Mischstufen bzw. Eingangsimpedanz des Zwischenfrequenzkreises. Auch im Reparaturbetrieb ist ein Neuabgleich wegen Mangels an notwendigen Prüfeinrichtungen oft nicht möglich und sehr teuer, so daß der Fernsehemfänger durch schlechte Anpassung zwischen Tunern und Zwischenfrequenzverstärker mehr oder weniger Reflexionen des Signals hervorruft.

Aufgabe und Lösung

Der Erfindung liegt deshalb die Aufgabe zugrunde, die Anpassung des Tuners an den Zwischenfrequenzverstärker unkritisch zu gestalten.

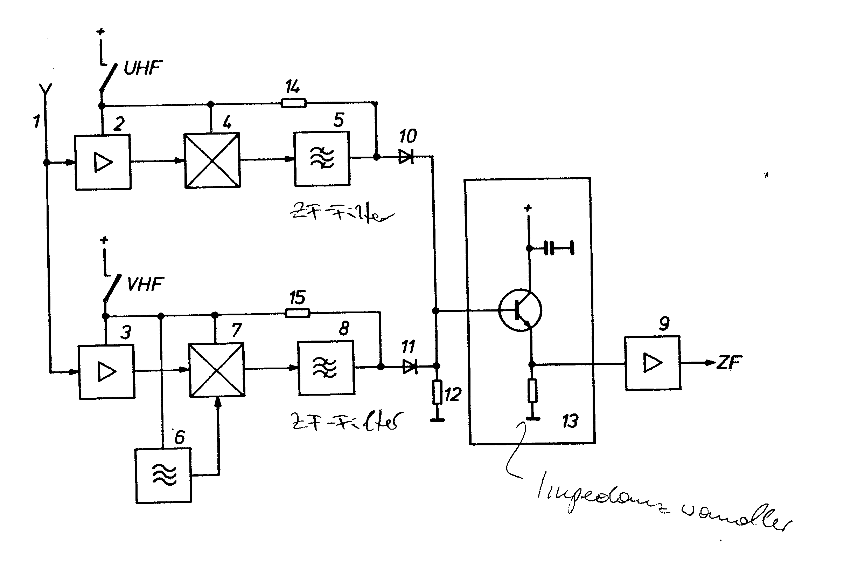

Nachstehend soll mit Hilfe der Zeichnung das Wesentliche der Erfindung an einem Ausführungsbeispiel erläutert werden.

Über die Antenne 1 gelangen die Hochfrequenzsignale an die Verstärker 2 für Signale im UHF-Frequenzbereich und 3 für die Signale im VHF-Frequenzbereich. Die Signale werden in bekannter Weise in eine Zwischenfrequenz umgeformt. Das geschieht im UHF-kanal mit Hilfe der selbstschwingenden Mischstufe 4, deren Zwischenfrequenzausgangsspannung einem Zwischenfrequenzbandfilter 5 zugeführt wird. Das VHF-Signal wird mit Hilfe einer in der Oszillatorstufe 6 erzeugten Oszillatorfrequenz in der Mischstufe 7 zur Zwischenfrequenz umgewandelt und dem Zwischenfrequenzbandfilter 8 zugeführt. Erfindungsgemäß werden die Zwischenfrequenzsignale nicht direkt dem ersten Zwischenfrequenzverstärker 9 zugeleitet, sondern über Entkopplungsdioden 10 und 11 an einen gegen Masse geschalten reellen Eingangs-Widerstand 12 gelegt, der an den Eingang eines als Emitterfolger ausgebildeten Impendanzwandlers 13 geschaltet ist. Der Ausgang dieses Emitterfolgers ist mit dem ersten Zwischenfrequenzverstärker 9 verbunden. Die UHF- bzw. VHF-Zwischenfrequenz-Signale werden über die mit Hilfe der Versorgungsspannung für die HF-Stufen der beiden Kanäle über Vorwiderstände 14 und 15 einschaltbaren Dioden 10 und 11 durchgeschaltet.

Durch die Erfindung wird der Vorteil erzielt, daß durch den reellen Emitterwiderstand des Emitterfolgers 13 der Einang des Zwischenfrequenzverstärkers 9 immer mit einem konstanten Wert abgeschlossen ist.

## Ansprüche

1. Schaltungsanordnung für Fernsehempfänger zur Verstärkung und Umsetzung von VHF- und UHF-Signalen in ein Zwischenfrequenzsignal, wobei für die VHF- und UHF-Signale je ein HF-Vorverstärker und eine Mischstufe vorgesehen ist, und wobei beide Zweige (UHF, VHF) über von den Betriebsspannungen für VHF/UHF-Stufen wechselweise durchschaltbare Entkopplungsdioden an einen Zwischenfrequenzverstärker anschaltbar sind, gekennzeichnet durch die Kombination folgender Merkmale:

   a) In jedem der beiden Zweige (UHF, VHF) ist ein separates Zwischenfrequenzfilter (5, 8) jeweils hinter der Mischstufe (4, 7) vorgesehen.

   b) Die Entkopplungsdioden (10, 11) sind mit dem gegen Masse geschalteten reellen Eingangs-Widerstand (12) eines Emitterfolgers (13) verbunden.

   c) Der Ausgang des Emitterfolgers (13) mit Masse geschaltetem reellen Emitter-widerstand ist mit dem Eingang des Zwischenfrequenzverstärkers (9) verbunden, an dem das verstärkte Zwischenfrequenzsignal abnehmbar ist.

## Claims

1. A circuit arrangement for television receivers for amplifying and converting VHF and UHF signals into an intermediate frequency signal, in which for each of the VHF and UHF signals there is provided one HF pre-amplifier and one mixing stage, and in which both branches (UHF, VHF) may be connected up to an intermediate frequency amplifier via decoupling diodes which can be through-connected alternaively by the operating voltages for VHF/UHF stages, characterised by the combination of the following features:

   a) in each of the two branches (UHF,VHF) a separate intermediate frequency filter (5,8) is provided in each case after the mixing stage (4,7).

b) the decoupling diodes (10,11) are connected to the real input resistor (12) connected to earth of an emitter follower (13).

c) the output of the emitter follower (13) with the real emitter resistance connected to earth is connected to the input of the intermediate frequency amplifier (9), at which the amplified intermediate frequency signal can be tapped off.

**Revendications**

1. Montage pour un récepteur de télévision destiné a amplifier et convertir des signaux VHF et UHF en un signal de fréquence intermédiaire, comprenant un préamplificateur HF et un étage mélangeur pour les signaux VHF et UHF, les deux branches (UHF, VHF) pouvant être reliées a un amplificateur de fréquence intermédiaire par des diodes de découplage rendues alternativement passantes par les tensions de service pour les étages VHF/UHF, caractérisé par la combinaison de caractéristiques suivantes :

a) Un filtre de fréquence intermédiaire séparé (5, 8) est prévu en aval de chaque étage mélangeur (4, 7) sur chacune des deux branches (UHF, VHF).

b) Les diodes de découplage (10, 11) sont reliées a la résistance d'entrée réelle (12) connectée à la masse d'un émetteur-suiveur (13).

c) La sortie de l'émetteur-suiveur (13) avec la résistance d'émetteur réelle connectée a la masse, est reliée a l'entrée de l'amplificateur de fréquence intermédiaire (9) qui délivre le signal de fréquence intermédiaire amplifié.

UHF

14

1

2

4

5

10

ZF Filter

VHF

15

3

7

8

11

6

ZF Filter

12

13

Impedanz wandler

9

ZF

EP 0 126 354 B1